(19) Europäisches Patentamt
European Patent Office
Office européen des brevets

(11) Veröffentlichungsnummer: **0 472 029 A1**

(12) **EUROPÄISCHE PATENTANMELDUNG**

(21) Anmeldenummer: **91113002.9**

(51) Int. Cl.[5]: **G03F 7/039**, G03F 7/004

(22) Anmeldetag: **02.08.91**

(30) Priorität: **16.08.90 DE 4025959**

(43) Veröffentlichungstag der Anmeldung:
**26.02.92 Patentblatt 92/09**

(84) Benannte Vertragsstaaten:
**BE DE FR GB IT NL**

(71) Anmelder: **BASF Aktiengesellschaft**
**Carl-Bosch-Strasse 38**
**W-6700 Ludwigshafen(DE)**

(72) Erfinder: **Nguyen Kim, Son, Dr.**
**Zedernweg 9**
**W-6944 Hemsbach(DE)**

(54) **Strahlungsempfindliches Gemisch und Verfahren zur Herstellung von Reliefmustern.**

(57) Die Erfindung betrifft ein strahlungsempfindliches Gemisch, im wesentlichen bestehend aus

einem in Wasser unlöslichen, in wäßrig-alkalischen Lösungen löslichen Bindemittel oder Bindemittelgemisch

und

einer bei Bestrahlung eine starke Säure bildenden Verbindung,

wobei das Gemisch zusätzlich eine in Gegenwart von Säure zur Kondensation befähigte organische Verbindung, insbesondere ein Acetal des Formaldehyds enthält.

Das strahlungsempfindliche Gemisch eignet sich zur Herstellung von Reliefstrukturen.



Rank Xerox (UK) Business Services

Die Erfindung betrifft strahlungsempfindliche Gemische, die negativ arbeitend sind. Diese Gemische enthalten in Wasser unlösliche, in wäßrigalkalischen Lösungen lösliche Bindemittel, eine unter Einwirkung von Strahlung eine starke Säure bildende Verbindung sowie zusätzlich eine in Gegenwart von Säure zur Kondensation befähigte organische Verbindung. Diese Gemische sind sensitiv gegenüber UV-, Elektronen- und Röntgenstrahlen und eignen sich besonders als Resistmaterial.

Negativ arbeitende strahlungsempfindliche Gemische sowie Verfahren zur Bildherstellung mittels dieser Gemische sind bekannt. Unter negativ arbeitenden Photoresists werden dabei solche verstanden, bei denen nach der bildmäßigen Belichtung der lichtempfindlichen Schicht die belichteten Bereiche dieser Schicht, gegebenenfalls nach einer zusätzlichen Wärmebehandlung, in der Entwicklerlösung, in der sie vor der Belichtung löslich waren, unlöslich sind.

Im allgemeinen basieren negativ arbeitende Photoresists auf photopolymerisierbaren Gemischen, die neben einem polymeren Bindemittel eine photopolymerisierbare Verbindung und einen Photoinitiator enthalten. Die am meisten verwendeten negativ arbeitenden Photoresists für die Herstellung integrierter Schaltungen enthalten fast ausnahmslos partiell cyclisiertes Polyisopren als vernetzbare Komponente und eine Diazid-Verbindung als lichtempfindlichen difunktionellen Vernetzer. Als Diazide sind hierbei solche der Struktur (A)

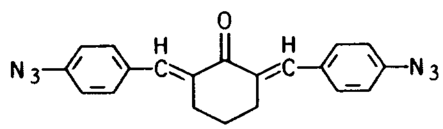

(A)

sehr gebräuchlich.

Neuerdings sind auch negativ arbeitende Photoresists, die aus teilcyclisiertem Polybutadien und Diaziden bestehen, im Handel erhältlich (vgl. auch Harita, Y., Ichigawa, M., Harada, K., Polym. Eng. Sci., 17 (1977), 372).

Eine Reihe negativ arbeitender Photoresists basiert auch auf der Photodimerisierung als Vernetzungsreaktion. Hierher gehören die Zimtsäurederivate und die ihnen im Aufbau verwandten Chalkone. Die Vernetzungsreaktion verläuft im wesentlichen als lichtinduzierte [2+2]-Cycloaddition unter Bildung von Cyclobutanen (vgl. Williams, J.L.R.: Fortschr. Chem. Forsch., 13 (1969), 227; Reiser, A., Egerton, P.L.: Photogr. Sci. Eng., 23 (1979), 144; M. Kato et al: J. Polym. Sci. part B, Polym. Lett. Ed. 8 (1970), 263; M. Kato et al: Photogr. Sci. Eng., 23 (1979), 207).

In den letzten Jahren hat auch noch ein schon längere Zeit bekannter Typ photodimerisierbarer Epoxidharze als Photoresist Verwendung gefunden (vgl. z.B. DE-A-14 47 016; DE-A-23 42 407; DE-A-25 53 346 sowie DE-A-24 49 926). Diese Harze tragen sowohl Gruppierungen, die Photocycloadditionen ermöglichen, z.B. Chalkonreste, als auch Epoxygruppen, die thermisch katalysiert nachvernetzt werden können (vgl. Photoresist, New York,: McGraw Hill (1975); GB-PS 892 111 und US-A 2 852 379).

Außer den negativ arbeitenden Photoresisten, die ein Diazid der oben genannten Struktur (A) enthalten, sind die Photoreaktionen nur im NUV-Bereich (d.h. bei 350 bis 450 nm) möglich. Neue Diazidverbindungen für den kurzwelligen UV-Bereich wurden in den letzten Jahren beschrieben. Dazu gehören Ketonverbindungen (vgl. J. Elektrochem. Soc. (1981) 6) sowie schwefelhaltige Diazidverbindungen (vgl. J. Elektrochem. Soc., 127 (1980), 2759).

Auch negativ arbeitende wäßrig-alkalisch entwickelbare Photoresists, die im kurzwelligen UV strukturierbar sind, sind bekannt. Hierzu werden Poly(p-vinylphenol) als Bindemittel und 3,3'-Diazidodiphenylsulfon verwendet (vgl. IEEE Trans. Electron Devices, ED. 28 (1981), 1306; IEEE Trans. Electron Devices, ED-28 (1981), 1284). Ein weiterer wäßrig-alkalisch entwickelbarer negativ arbeitender Photoresist basiert auf einem Oniumsalz und Methylacrylamidoglycolatmethylether (vgl. Hult et al; Polymers for high Tech. ACS Symposium Series 346 (1987), 162 bis 169), der auf dem Prinzip der säurekatalytischen Selbst-Kondensation zur Vernetzung des Bindemittels beruht.

Eine weitere photopolymerisierbare Zusammensetzung, die auf einem säurehärtbaren Material und einem Jodoniumalz als Säurespender basiert, ist aus der DE-A-2 602 574 bekannt.

Auch säurekatalytische Vernetzer, zu denen beispielsweise die als Zwischenprodukte bei der Kondensation von Phenol/Formaldehyd-Harz erhältlichen Arylmethylolverbindungen gehören, waren bereits bekannt (vgl. Progr. Org. Coat. 9 (1981), 107; DE-A-29 04 961; Plastics and Rubber Processing and Application 1 (1981), 39; DE-A-32 47 754; EP-A-01 39 309; JP 3051424-A). Auch für photostrukturierbares Aufzeichnungsmaterial hat dieser säurekatalytische Vernetzer Anwendung gefunden. In EP-A-0282724 wird über ein neues negativ arbeitendes System, das auf Poly(p-hydroxystyrol),einem Säurespender und einem Vernetzer

mit mindestens zwei geschützten Methylolgruppen basiert, berichtet; anstelle Poly(p-hydroxystyrol) kann auch m-Kresol-Formaldehyd-Harz eingesetzt werden. Analog wurde in PCT/US 87/02743 ein anderes Negativ-System beschrieben, in dem auch Poly(p-hydroxystyrol) oder m-Kresol-Formaldehyd-Novolake als Bindemittel, ein 1,2-Chinondiazid als Säurespender und ein 2,6-Dimethylol-p-Kresol als Vernetzer eingesetzt wird. Nachteile der beiden obengenannten Systeme sind: hohe Herstellungskosten aller Bindemittel auf Basis von Poly(p-hydroxystyrol) sowie die hohe optische Dichte (≙ niedrige Transmittance) im kurzwelligen Bereich ($\lambda \leqq 300$ nm) von m-Kresol-Formaldehyd-Harz; daher werden Novolake auf Basis von m-Kresol und Formaldehyd vorzugsweise für Resiste, die im mittleren UV-Bereich (MID-UV: $\lambda$ = 300-380 nm) transparent sind, eingesetzt. Auch eine andere thermisch vernetzende Verbindung, die ein Harnstoff- bzw. Urethan-Formaldehydkondensatprodukt ist, wurde neuerdings in DE-A-3 711 264 als Vernetzer für lichtempfindliche Gemische beschrieben.

Aufgabe der vorliegenden Erfindung war es, neue strahlungsempfindliche Gemische aufzuzeigen, die sich als hochaktive strahlungsempfindliche Systeme für die Herstellung von im kurzwelligen UV lichtempfindlichen Schichten, die sich mit wäßrig-alkalischen Lösungen entwickeln lassen, eignen.

Überraschenderweise gelingt dies dadurch, daß organische Verbindungen der allgemeinen Formel (I) oder Bindemittel mit Gruppierungen der allgemeinen Formel (II) als säurevernetzbare Gruppierungen eingesetzt werden.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch

und

(b) einer bei Bestrahlung eine starke Säure bildenden Verbindung,

das dadurch gekennzeichnet ist, daß das Gemisch zusätzlich eine in Gegenwart von Säure zur Kondensation befähigte organische Verbindung (c) der allgemeinen Formel (I)

$R'O\text{-}CH_2\text{-}OR''$ (I)

enthält, worin R' und R'' untereinander gleich oder verschieden sind und für Alkyl, halogensubstituiertes Alkyl, Aryl oder Aralkyl stehen;

oder

die Komponente (a) mindestens eine Gruppierung der allgemeinen Formel (II)

$R'O\text{-}CH_2\text{-}O\text{-}$ (II)

enthält, worin R' die oben angegebene Bedeutung hat.

Im erfindungsgemäßen strahlungsempfindlichen Gemisch wird vorzugsweise als Bindemittel (a) ein phenolisches Harz mit freien ortho- und/oder para-Stellungen, insbesondere ein Novolak mit einem mittleren Molekulargewicht $\overline{M}_w$ zwischen 200 und 30.000, sowie Poly-(p-hydroxistyrol), Poly-(p-hydroxi-$\alpha$-methylstyrol) oder ein Copolymerisat aus p-Hydroxistyrols und p-Hydroxi-$\alpha$-methylstyrol mit mittlerem Molekulargewicht $\overline{M}_w$ zwischen 200 und 40.000 eingesetzt.

Im erfindungsgemäßen strahlungsempfindlichen Gemisch wird die Komponente (a) im allgemeinen in einer Menge von 60 bis 99,5 Gew.-%, bezogen auf die Gesamtmenge der Komponenten (a) + (b) + (c), eingesetzt.

Das erfindungsgemäße strahlungsempfindliche Gemisch enthält als bei Bestrahlung eine starke Säure bildende Verbindung (b), vorzugsweise ein Oniumsalz der allgemeinen Formel (III) oder (IV)

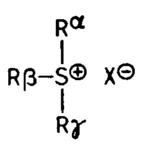

(III)

oder

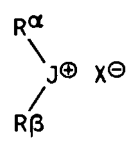

(IV)

worin $R\alpha$, $R\beta$ und $R\gamma$ untereinander gleich oder verschieden sind und für Alkyl mit 1 bis 8 Kohlenstoffatomen, Aryl, Aralkyl oder den Rest

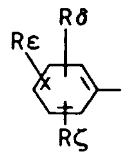

stehen, worin Rδ, Rε und Rζ untereinander gleich oder verschieden sind und für H, OH, Halogen, Alkyl oder Alkoxi stehen und $X^{\ominus}$ = $AsF_6^{\ominus}$, $SbF_6^{\ominus}$, $PF_6^{\ominus}$, $BF_4^{\ominus}$, $C10_4^{\ominus}$ oder $CF_3SO_3^{\ominus}$ ist, wobei Komponente (b) im allgemeinen in einer Menge von 0,5 bis 15 Gew.-%, bezogen auf die Gesamtmenge des strahlungsempfindlichen Gemisches (a) + (b) + (c) enthalten ist.

Die als Komponente (c) zu verwendenden organischen Verbindungen der allgemeinen Formel (I) weisen vorzugsweise Siedepunkte (bei Normaldruck) von über 180 °C auf.

Als Komponente (c) bevorzugt sind Acetale aus Formaldehyd und Alkoholen und/oder Phenolen, insbesondere Acetale aus Formaldehyd und Benzylalkohol oder substituiertem Benzylalkohol ist. Diese Acetale werden vorzugsweise in Gegenwart eines sauren Katalysators unter Verwendung von Paraformaldehyd, Trioxan, Tetroxan oder niedersiedenden Acetalen des Formaldehyds als Formaldehydquelle hergestellt.

Komponente (c) ist im allgemeinen in einer Menge von bis zu 45 Gew.-%, bezogen auf die Gesamtmenge des strahlungsempfindlichen Gemisches (a) + (b) + (c) enthalten.

Eine Ausführungsform der vorliegenden Erfindung besteht auch darin, daß das strahlungsempfindliche Gemisch nur Bindemittel (a) mit einer Gruppierung der allgemeinen Formel (II) und keine Komponente (c) enthält. Das Bindemittel (a) enthält in diesem Falle vorzugsweise die Struktur (V)

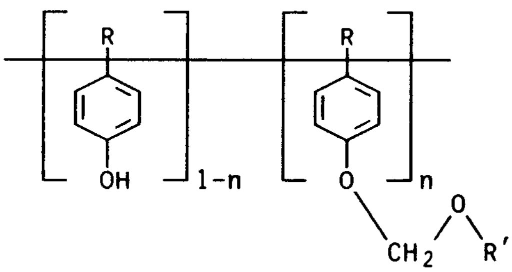

(V)

worin

R = H oder $CH_3$
n = 0,05 bis 0,5 und
R' die oben angegebene Bedeutung hat.

Das Bindemittel (a) mit der Struktur (v) wird vorzugsweise aus Poly(p-hydroxistyrol) oder Poly(p-hydroxi-α-methylstyrol) und einem Acetal des Formaldehyds in Gegenwart eines sauren Katalysators erhalten.

Im erfindungsgemäßen strahlungsempfindlichen Gemisch, das Bindemittel (a) mit einer Gruppierung der Formel (II) aber keine Komponente (c) enthält, ist die Komponente (a) in einer Menge von 85 bis 99,5 Gew.-%, bezogen auf die Gesamtmenge des Gemisches (a) + (b) enthalten.

Die erfindungsgemäßen strahlungsempfindlichen Gemische können zusätzlich einen Sensibilisator enthalten, der Strahlung absorbiert und auf Komponente (b) überträgt, sowie zusätzlich bis zu 1 Gew.-%, bezogen auf die Gesamtmenge der Komponenten (a) + (b) + (c) eines Haftvermittlers, Tensids oder Farbstoffs.

Gegenstand der vorliegenden Erfindung ist außerdem ein Verfahren zur Herstellung lichtempfindlicher Beschichtungsmaterialien, wobei ein erfindungsgemäßes strahlungsempfindliches Gemisch eingesetzt wird, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120 °C, bildmäßiges Belichten, Erhitzen auf Temperaturen von 70 bis 160 °C und Entwickeln mit einer wäßrig-alkalischen Lösung, das dadurch gekennzeichnet ist, daß ein erfindungsgemäßes strahlungsempfindliches Gemisch eingesetzt wird.

Das erfindungsgemäße strahlungsempfindliche Gemisch zeichnet sich besonders durch gute Haftung, hohe Auflösung im Submikronbereich, hohe Empfindlichkeit im DUV-Bereich sowie sehr gute Reproduzierbarkeit aus.

Zu den Aufbaukomponenten des erfindungsgemäßen strahlungsempfindlichen Gemisches sowie zu dessen Weiterverarbeitung wird im einzelnen folgendes ausgeführt.

Das erfindungsgemäße strahlungsempfindliche Gemisch enthält als Komponente (a) ein in Wasser unlösliches, in wäßrig-alkalischen Lösungen lösliches Bindemittel oder Bindemittelgemisch.

(a) Als in Wasser unlösliche, in wäßrig-alkalischen Lösungen lösliche Bindemittel (a) kommen in Frage phenolische Harze, bevorzugt solche, deren ortho- und/oder para-Stellungen an den Phenylresten zu mindestens 20 %, vorzugsweise bis zu 66 %, frei von Substituenten sind, wie z.B. Novolake mit mittleren Molekulargewichten $\overline{M}_W$ zwischen 200 und 30.000, vorzugsweise zwischen 500 und 5000, beispielsweise Novolake auf Basis von p-Kresol/Formaldehyd, insbesondere Poly-(p-hydroxistyrole), Poly(-p-hydroxi-α-methylstyrole) und Copolymerisate aus p-Hydroxistyrol und p-Hydroxi-α-methylstyrol, beispielsweise jeweils mit mittleren Molekulargewichten $\overline{M}_W$ zwischen 200 und 60.000, vorzugsweise 5000 bis 40.000, sowie Gemische derartiger phenolischer Harze.

Als Novolake kommen beispielsweise auch solche Novolake in Frage, wie sie in Novolak Resins Used in Positiv Resist Systems von T. Pampalone in Solid State Technology, June 1984, Seite 115 bis 120, beschrieben sind. Für spezielle Anwendungen, z.B. für Belichtung im kurzwelligen UV-Gebiet kommen bevorzugt Novolake aus p-Kresol und Formaldehyd in Frage.

Bevorzugt als Komponente (a) sind solche, die mindestens eine Gruppierung der allgemeinen Formel (II) enthalten.

Derartige Produkte lassen sich nach üblichen Methoden herstellen, beispielsweise indem man phenolische Polymere, beispielsweise Poly(p-hydroxistyrol) mit Formaldehyddimethylacetal unter Säurekatalyse reagieren läßt (vgl. z.B. 3rd Synthesis, 244 (1976), J.P. Yardley and H. Fletcher).

Die erfindungsgemäßen strahlungsempfindlichen Gemische enthalten Komponente (a) im allgemeinen in Mengen von 60 bis 99,5 Gew.-% der Gesamtmenge der Komponenten (a) + (b) + (c) bzw. im Falle des Fehlens einer Komponente (c) in Mengen von 85 bis 99,5 Gew.-% der Gesamtmengen (a) + (b).

(b) Als bei Bestrahlung eine starke Säure bildende Verbindungen (b) kommen im Prinzip alle Verbindungen in Frage, die diese Eigenschaften aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen den allgemeinen Formeln (III) bzw. (IV)

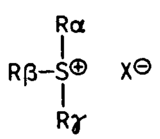

(III)

bzw.

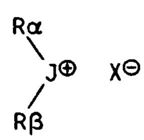

(IV)

worin

$R\alpha$, $R\beta$ und $R\gamma$ untereinander gleich oder verschieden sind und für Alkyl, beispielsweise mit 1 bis 5, vorzugsweise 1 oder 2 Kohlenstoffatomen, Aryl, wie z.B. Phenyl,

Aralkyl, wie z.B. Benzyl,

oder den Rest

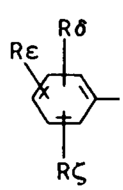

stehen, worin $R\delta$, $R\epsilon$ und $R\zeta$ untereinander gleich oder verschieden sind und für Wasserstoff, OH, Halogen, wie z.B. Chlor oder Brom,

Alkyl, beispielsweise mit 1 bis 5 Kohlenstoffatomen, vorzugsweise Methyl oder tert.-Butyl,

oder Alkoxi, beispielsweise mit 1 bis 5 Kohlenstoffatomen, vorzugsweise Methoxi

stehen und $X^{\ominus}$ = $AsF_6^{\ominus}$, $SbF_6^{\ominus}$, $PF_6^{\ominus}$, $BF_4^{\ominus}$, $C10_4^{\ominus}$ oder $CF_3SO_3^{\ominus}$ (= Triflat) ist.

Beispiele für besonders gut geeignete Komponenten (b) sind Triphenylsulfoniumsalze und Diphenyliodoniumsalze, Tris(4-hydroxiphenyl)-sulfoniumsalze, Tris(trimethylsilyloxi-phenyl)sulfoniumsalze, Tris(4-tert.-butoxicarbonyl-oxiphenyl)sulfoniumsalze und Tris(4-ethyloxicarbonyl-oxiphenyl)sulfoniumsalze, jeweils mit $X^{\ominus}$, $AsF_6^{\ominus}$, $AsF_6^{\ominus}$, $PF_6^{\ominus}$, $SbF_6^{\ominus}$, $BF_4^{\ominus}$ und $CF_3SO_3^{\ominus}$ als Gegenionen.

Auch Gemische der unter (b) genannten Verbindungen können eingesetzt werden. Komponente (b) ist im erfindungsgemäßen strahlungsempfindlichen Gemisch im allgemeinen in Mengen von 0,5 bis 15, vorzugsweise 2 bis 10 Gew.%, bezogen auf die Gesamtmenge des strahlungsempfindlichen Gemisches (a) + (b) + (c) enthalten.

(c) Als Komponente (c) enthält das erfindungsgemäße strahlungsempfindliche Gemisch eine in Gegenwart von Säure zur Kondensation befähigte organische Verbindung der allgemeinen Formel (I)

$R'O\text{-}CH_2\text{-}OR''$

die vorzugsweise einen Siedepunkt von >180 °C aufweist, worin R' und R" untereinander gleich oder verschieden sind und für geradkettiges oder verzweigtes Alkyl, beispielsweise mit 1 bis 8, vorzugsweise 1 bis 4 Kohlenstoffatomen, z.B. Methyl, tert.-Butyl, halogensubstituiertes Alkyl, beispielsweise Chloralkyl, mit 1 bis 4 Kohlenstoffatomen, Aryl, beispielsweise Phenyl, Aralkyl, beispielsweise Benzyl oder p-Methylbenzyl stehen.

Die Herstellung der Komponente (c) kann beispielsweise gemäß 3rd Synthesis, 244 (1956), Tetrahedron Letter, 661 (1978), Tetrahedron Letter, 1033 (1976) oder Organikum, 13. Auflage, S. 431 erfolgen.

Beispiele für derartige Verbindungen (c) sind:

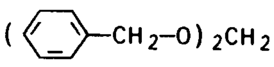 ; 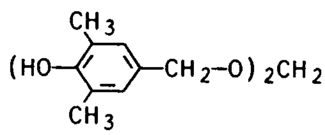 ; 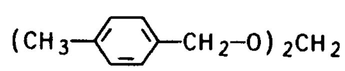 ;

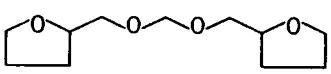 ; 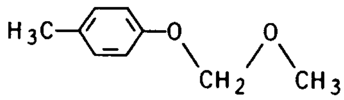

Komponente (c) ist, sofern Komponente (a) keine Gruppierungen der allgemeinen Formel (II) aufweist, im allgemeinen in einer Menge von 5 bis 45, vorzugsweise 10 bis 30 Gew.-%, bezogen auf die Gesamtmenge der Komponenten (a) + (b) + (c) im erfindungsgemäßen strahlungsempfindlichen Gemisch enthalten.

Wenn Komponente (a) jedoch eine genügende Menge an Gruppierungen der allgemeinen Formel (II) enthält, kann auch auf Komponente (c) verzichtet werden.

Gegebenenfalls können den erfindungsgemäßen strahlungsempfindlichen Gemischen auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch Farbstoffe, die als Sensibilisatoren wirken, verwendet werden.

Weiterhin können zusätzlich bis zu 1 Gew.-%, bezogen auf die Gesamtmenge der Komponenten (a) + - (b) + (c), eines Haftvermittlers, Netzmittels, Farbstoffs oder Weichmachers zugesetzt werden.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether, Ester und aromatische Kohlenwasserstoffe, sowie Mischungen derselben in Frage. Besonders bevorzugt sind Alkylenglykolmonoalkylether, wie beispielsweise Ethyl-cellosolve, Butylglykol, Methylcellosolve und 1-Methoxy-2-propanol, Alkylenglykol-alkylether-ester, wie beispielsweise Methyl-cellosolve-acetat, Ethyl-cellosolve-acetat, Methylpropylenglykol-acetat, und Ethylpropylenglykol-acetat, Ketone, wie beispielsweise Cyclohexanon, Cyclopentanon und Methyl-ethyl-keton, sowie Acetate, wie Butylacetat, und Aromaten, wie Toluol und xylol. Die Auswahl der entsprechenden Lösungsmittel, sowie deren Mischung richtet sich nach der Wahl des jeweiligen phenolischen Polymers bzw. Novolaks und der photoempfindlichen Komponente.

Bei dem erfindungsgemäßen Verfahren zur Herstellung von Reliefmustern bzw. Reliefstrukturen wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60 und 160 °C in wäßrig-

alkalischen Lösungsmitteln abnimmt und die unbelichteten Bereiche selektiv mit dem alkalischen Entwickler entfernt werden können.

Das erfindungsgemäße strahlungsempfindliche Gemisch eignet sich besonders als Photoresist zur Herstellung von Reliefstrukturen für Halbleiterbauelemente.

Die das erfindungsgemäße strahlungsempfindliche Gemisch enthaltenden Photoresistlösungen können durch ein Filter mit einem Porendurchmesser von etwa 0,2 µm filtriert werden und werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) z.B. bei 1000 bis 10.000 U/Minute, aufgetragen, getrocknet (z.B. 1 bis 5 Minuten bei Temperaturen zwischen 70 und 120, vorzugsweise 80 bis 90 °C) und mit einer geeigneten Lichtquelle durch eine Photomaske z.B. eine chrombeschichtete strukturierte Quarzmaske) bildmäßig belichtet. Als Lichtquellen eignen sich insbesondere kurzwellige UV-Strahlen (deep UV) mit Wellenlängen zwischen 200 und 300 nm sowie auch Elektronen- oder Röntgenstrahlen. Besonders geeignete Lichtquellen sind Quecksilberlampen sowie Excimer-Laser von KrF ($\lambda$ = 248 nm). Nach dem bildmäßigen Belichten wird -gegebenenfalls nach kurzem Ausheizen (2 Sekunden bis 5 Minuten) (postbake) bei Temperaturen zwischen 60 und 160 °C - mit üblichen wäßrigalkalischen Entwicklerlösungen - im allgemeinen bei pH-Werten zwischen 12 und 14 - entwickelt, wobei sich die unbelichteten Bereiche selektiv ablösen, während in den belichteten Bereichen nur wenig Abtrag stattfindet. Die Auflösung liegt im Submikron-Bereich. Die für die erfindungsgemäßen strahlungsempfindlichen Gemische benötigte Belichtungsenergie liegt im allgemeinen zwischen 5 und 30 $mJ/cm^2$ bei Schichtdicken von 1 µm.

Die in den Beispielen angegebenen Teile und Prozente sind, soweit nicht anders angegeben, Gewichtsteile bzw. Gewichtsprozente.

Synthese der Ausgangsverbindungen

1) Formaldehyddibenzylacetal

In einem Dreihalskolben mit Rührer, Rückflußkühler und Wasserabscheider werden 20 Teile Benzylalkohol, 11 Teile Paraformaldehyd und 50 Teile Toluol vorgelegt. Nach Zugabe von 0,5 Teilen $H_2SO_4$ conz. wird das Gemisch unter Rückfluß 3 Stunden erhitzt. Danach wird das Gemisch in 500 Teile Wasser gegeben. Die organische Phase wird über $Na_2SO_4$ getrocknet und unter ölvakuum destilliert.

Ausbeute: 17,9 Teile (≙ 84,8 % d.Th.); Kp = 118 °C/0,02 mbar.

2) Methoxymethyl-4-methylphenylether

21,6 Teile p-Kresol
60,8 Teile Formaldehyddimethylacetal
100 Teile Methylenchlorid
0,2 Teile p-Toluolsulfonsäure
100 Teile Molekularsieb Typ 514 (Fa. Grace)

In einer Soxhlet-Apparatur (Molekularsieb befindet sich im Soxhlet) werden die oben angegebenen Bestandteile zusammengegeben und 24 Stunden erhitzt. Das entstehende Methanol wird durch Molekularsieb abgefangen. Danach wird das Gemisch mit 10 %iger NaOH-Lösung extrahiert. Die organische Phase wird über $Na_2SO_4$ getrocknet und unter Vakuum destilliert.

Ausbeute: 10,1 Teile (≙ 33,5 % d.Th.); Kp = 100 °C/25 mbar.

3) Methoxymethyl-haltiges Poly(p-hydroxistyrol)

6 Teile Poly(p-hydroxistyrol) ($\overline{M}_W$ = 9000 g/mol)
80 Teile Formaldehyddimethylacetal
100 Teile Methylenchlorid
0,2 Teile p-Toluolsulfonsäure
70 Teile Molekularsieb Typ 514 (Fa. Grace)

In einer Soxhlet-Apparatur (Molekularsieb befindet sich im Soxhlet) werden die oben angegebenen Bestandteile zusammengegeben und 5 Stunden erhitzt. Nach dem Abkühlen wird die Lösung in 2000 Teilen Ligroin gefällt und abgesaugt. Das Produkt wird nochmals in Ethanol/Aceton (1:1) gelöst, in 1000 Teilen Wasser gefällt, abgesaugt und im Vakuumtrockenschrank bei 60 °C getrocknet.

## Beispiel 1

Eine Photoresistlösung wird aus 80 Teilen Poly(p-hydroxistyrol) ($\overline{M}_W$ = 9000 g/mol), 5 Teilen Triphenylsulfoniumhexafluoroarsenat, 15 Teilen Formaldehyddibenzylacetal und 260 Teilen Methylglykolacetat hergestellt. Die Lösung wird anschließend durch einen Filter mit einem Porendurchmesser von 0,2 µm filtriert.

Die Resistlösung wird auf einen oxidierten Siliciumwafer in einer Schichtdicke von 1 µm aufgeschleudert, auf einer Heizplatte eine Minute bei 90 °C getrocknet und anschließend mit einer Testmaske im Kontakt-Verfahren mit Excimerlaser der Wellenlänge $\lambda$ = 248 nm belichtet. Danach wird der Wafer 1

Minute bei 120 °C ausgeheizt und mit einem wäßrig-alkalischen Entwickler vom pH-Wert 13 bis 14,5 entwickelt. Die Empfindlichkeit für 1 µm-Schichtdicke beträgt 10 $mJ/cm^2$.

Beispiel 2

Eine Photoresistlösung wird aus 77 Teilen Poly(p-hydroxistyrol) ($\overline{M}_W$ = 9000 g/mol), 3 Teilen Tris(p-hydroxyphenyl)sulfoniumtriflat, 20 Teilen Methoxymethyl-4-methylphenylether und 260 Teilen α-Methoxy-2-propanol hergestellt. Mit dieser Resistlösung wird dann wie in Beispiel 1 verfahren.

Die Empfindlichkeit für 1 µm-Schichtdicke beträgt 27 $mJ/cm^2$.

Beispiel 3

Eine Photoresistlösung wird aus 97 Teilen methoxymethylhaltigem Poly(p-hydroxistyrol) (Ausgangsverbindung 3), 3 Teilen Tris(p-hydroxyphenyl)-sulfoniumtriflat und 280 Teilen 1-Methoxy-2-propanol hergestellt. Mit dieser Resistlösung wird dann wie in Beispiel 1 verfahren.

Die Empfindlichkeit für 1 µm-Schichtdicke beträgt 15 $mJ/cm^2$.

**Patentansprüche**

**1.** Strahlungsempfindliches Gemisch, im wesentlichen bestehend aus

(a) einem in Wasser unlöslichen, in wäßrig-alkalischen Lösungen löslichen Bindemittel oder Bindemittelgemisch

und

(b) einer bei Bestrahlung eine starke Säure bildenden Verbindung,

dadurch gekennzeichnet, daß das Gemisch zusätzlich eine in Gegenwart von Säure zur Kondensation befähigte organische Verbindung (c) der allgemeinen Formel (I)

$R'O\text{-}CH_2\text{-}OR''$ (I)

enthält, worin R' und R'' untereinander gleich oder verschieden sind und für Alkyl, halogensubstituiertes Alkyl, Aryl oder Aralkyl stehen;

oder

die Komponente (a) mindestens eine Gruppierung der allgemeinen Formel (II)

$R'O\text{-}CH_2\text{-}O\text{-}$ (II)

enthält, worin R' die oben angegebene Bedeutung hat.

**2.** Strahlungsempfindliches Gemisch nach Anspruch 1, dadurch gekennzeichnet, daß als Bindemittel (a) ein phenolisches Harz mit freien ortho- und/oder para-Stellungen eingesetzt wird.

**3.** Strahlungsempfindliches Gemisch nach Anspruch 2, dadurch gekennzeichnet, daß als phenolisches Harz ein Novolak mit einem mittleren Molekulargewicht $\overline{M}_W$ zwischen 200 und 30.000 eingesetzt wird.

**4.** Strahlungsempfindliches Gemisch nach Anspruch 1 oder 2, dadurch gekennzeichnet, daß als Bindemittel (a) Poly-(p-hydroxistyrol), Poly-(p-hydroxi-α-methylstyrol) oder ein Copolymerisat aus p-Hydroxistyrol und p-Hydroxi-α-methylstyrol eingesetzt wird, wobei das mittlere Molekulargewicht $\overline{M}_W$ des Bindemittels (a) zwischen 200 und 60.000 beträgt.

**5.** Strahlungsempfindliches Gemisch nach einem der vorhergehenden Ansprüche, dadurch gekennzeichnet, daß als Komponente (a) ein Gemisch aus Novolak und einem Bindemittel gemäß Anspruch 4 eingesetzt wird.

**6.** Strahlungsempfindliches Gemisch nach einem der vorhergehenden Ansprüche, dadurch gekennzeichnet, daß Komponente (a) in einer Menge von 60 bis 99,5 Gew.-%, bezogen auf die Gesamtmenge der Komponenten (a) + (b) + (c), enthalten ist.

**7.** Strahlungsempfindliches Gemisch nach einem der vorhergehenden Ansprüche, dadurch gekennzeichnet, daß als bei Bestrahlung eine starke Säure bildende Verbindung (b) ein Oniumsalz der allgemeinen Formel (III) oder (IV)

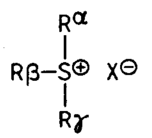

(III)

oder

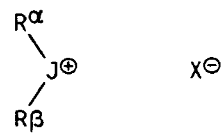

(IV)

eingesetzt wird, worin $R^{\alpha}$, $R\beta$ und $R\gamma$ untereinander gleich oder verschieden sind und für Alkyl mit 1 bis 8 Kohlenstoffatomen, Aryl, Aralkyl oder den Rest

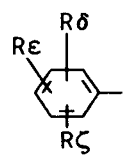

stehen, worin $R\delta$, $R\epsilon$ und $R\zeta$ untereinander gleich oder verschieden sind und für H, OH, Halogen, Alkyl oder Alkoxi stehen und $X^{\ominus}$ = $AsF_6^{\ominus}$, $SbF_6^{\ominus}$, $PF_6^{\ominus}$, $BF_4^{\ominus}$, $C10_4^{\ominus}$ oder $CF_3SO_3^{\ominus}$ ist.

**8.** Strahlungsempfindliches Gemisch nach einem der vorhergehenden Ansprüche, dadurch gekennzeichnet, daß Komponente (b) in einer Menge von 0,5 bis 15 Gew.-%, bezogen auf die Gesamtmenge des strahlungsempfindlichen Gemisches (a) + (b) + (c), enthalten ist.

**9.** Strahlungsempfindliches Gemisch nach einem der vorhergehenden Ansprüche, dadurch gekennzeichnet, daß Komponente (c) einen Siedepunkt (bei Normaldruck) von über 180 °C aufweist.

**10.** Strahlungsempfindliches Gemisch nach einem der vorhergehenden Ansprüche, dadurch gekennzeichnet, daß Komponente (c) ein Acetal aus Formaldehyd und einem Alkohol und/oder Phenol ist.

**11.** Strahlungsempfindliches Gemisch nach Anspruch 10, dadurch gekennzeichnet, daß Komponente (c) ein Acetal aus Formaldehyd und Benzylalkohol oder substituiertem Benzylalkohol ist.

**12.** Strahlungsempfindliches Gemisch nach einem der Ansprüche 10 oder 11, dadurch gekennzeichnet, daß Komponente (c) in Gegenwart eines sauren Katalysators unter Verwendung von Paraformaldehyd, Trioxan, Tetroxan oder niedersiedenden Acetalen des Formaldehyds als Formaldehydquelle hergestellt worden ist.

**13.** Strahlungsempfindliches Gemisch nach einem der vorhergehenden Ansprüche, dadurch gekennzeichnet, daß Komponente (c) in einer Menge bis zu 45 Gew.-%, bezogen auf die Gesamtmenge des strahlungsempfindlichen Gemisches (a) + (b) + (c) enthalten ist.

**14.** Strahlungsempfindliches Gemisch nach einem der vorhergehenden Ansprüche, dadurch gekennzeichnet, daß das Bindemittel (a) eine Gruppierung der allgemeinen Formel (II) und keine Komponente (c) enthält.

**15.** Strahlungsempfindliches Gemisch nach Anspruch 14, dadurch gekennzeichnet, daß das Bindemittel (a) die Struktur (V) enthält,

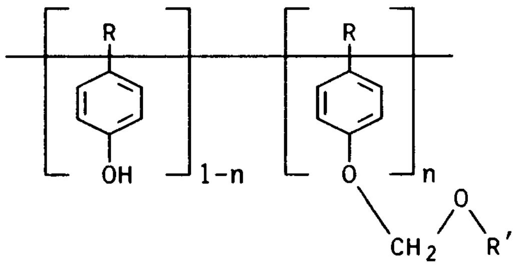

(V)

worin

R = H oder $CH_3$

n = 0,05 bis 0,5 und

R' die in Anspruch 1 angegebene Bedeutung hat.

**16.** Strahlungsempfindliches Gemisch nach einem der vorhergehenden Ansprüche, dadurch gekennzeichnet, daß das Bindemittel (a) der Struktur (V) aus Poly(p-hydroxistyrol) oder Poly(p-hydroxi-$\alpha$-methylstyrol) und einem Acetal des Formaldehyds in Gegenwart eines sauren Katalysators erhalten worden ist.

**17.** Strahlungsempfindliches Gemisch nach einem der Ansprüche 14 bis 16, dadurch gekennzeichnet, daß Komponente (a) in einer Menge von 85 bis 99,5 Gew.-%, bezogen auf die Gesamtmenge des Gemischs (a) + (b) enthalten ist.

**18.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**19.** Strahlungsempfindliches Gemisch nach einem der vorhergehenden Ansprüche, dadurch gekennzeichnet, daß es zusätzlich bis zu 1 Gew.-%, bezogen auf die Gesamtmenge der Komponenten (a) + (b) + (c) eines Haftvermittlers, Tensids oder Farbstoffs enthält.

**20.** Verfahren zur Herstellung lichtempfindlicher Beschichtungsmaterialien, dadurch gekennzeichnet, daß ein strahlungsempfindliches Gemisch gemäß einem der vorhergehenden Ansprüche eingesetzt wird.

**21.** Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120 °C, bildmäßiges Belichten, Erhitzen auf Temperaturen von 70 bis 160 °C und Entwickeln mit einer wäßrig-alkalischen Lösung, dadurch gekennzeichnet, daß ein strahlungsempfindliches Gemisch nach einem der vorhergehenden Ansprüche eingesetzt wird.

Europäisches Patentamt

# EUROPÄISCHER RECHERCHENBERICHT

Nummer der Anmeldung

**EP 91 11 3002**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | EP-A-0 282 724 (INTERNATIONAL BUSINESS MACHINES CORPORATION)<br>* das ganze Dokument * * | 1 | G 03 F 7/039<br>G 03 F 7/004 |
| A | EP-A-0 232 972 (ROHM AND HAAS COMPANY)<br>* Ansprüche 1,2 * * | 1 | |
| A | US-A-3 917 483 (LIMBURG W.W., MARSH D.G)<br>* Ansprüche * * | 1 | |

RECHERCHIERTE SACHGEBIETE (Int. Cl.5)

G 03 F

Der vorliegende Recherchenbericht wurde für alle Patentansprüche erstellt

| Recherchenort | Abschlußdatum der Recherche | Prüfer |
|---|---|---|
| Den Haag | 20 Dezember 91 | LUDI M.M.B. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument